# EUROPEAN PATENT SPECIFICATION

(11) **EP 4 362 107 B1**
(45) Date of publication and mention of the grant of the patent: **30.09.2026**
(21) Application number: 22213852.1
(22) Date of filing: 15.12.2022
(51) Int. Cl.: H10D 30/67

(54) **DISPLAY PANEL AND METHOD OF MANUFACTURING SAME, AND DISPLAY DEVICE**
ANZEIGETAFEL UND VERFAHREN ZUR HERSTELLUNG DAVON SOWIE ANZEIGEVORRICHTUNG
PANNEAU D'AFFICHAGE ET SON PROCÉDÉ DE FABRICATION, ET DISPOSITIF D'AFFICHAGE

(30) Priority: 25.10.2022 CN 202211311534
(43) Date of publication of application: 01.05.2024
(73) Proprietor: TCL CHINA STAR OPTOELECTRONICS TECHNOLOGY CO., LTD., Shenzhen, Guangdong 518132 (CN)
(72) Inventor: ZHOU, Kai, Shenzhen, 518132 (CN); LUO, Chuanbao, Shenzhen, 518132 (CN)
(74) Representative: Patentanwälte Olbricht Buchhold Keulertz

(56) References cited:
- KR-A- 20140 001 117
- US-A1- 2015 214 379
- US-A1- 2020 295 054
- US-A1- 2022 013 549

## Description

### FIELD OF INVENTION

The present application relates to a technical field of displays, and particularly to a display panel and a method of manufacturing the same.

### BACKGROUND OF INVENTION

Micro light-emitting diodes (micro-LEDs) and mini-LEDs are emerging display technologies that use current-driven displays.

With ever-increasing requirements of better image quality for high-definition display panels, it is inevitable now to improve resolution and display image quality. However, in current mini/micro LED displays, both sides of semiconductor layers of thin-film transistors are generally conductorized to form source and drain contact regions. Source and drain electrodes are connected to the semiconductor layers through the source and drain contact regions, and channel regions are located between the source and drain contact regions. Lengths of the channel regions are generally determined by lengths of gate electrodes, making them difficult to achieve thin-film transistors with short channels, which is not conducive to reduction of the size of the thin-film transistors, rendering achievement of high resolution difficult.

Reference document D1 (Pub. No. US2020/0295054A1) discloses a thin film transistor, comprising a substrate, and a source and drain that make electrical contact with the active layer, wherein the source an drain each comprise a first sub-electrode and a second sub-electrode that are stacked along a thickness of the active layer, and the first sub-electrode is closer to the active layer relative to the second sub-electrode. An area of an overlapping region between an orthographic projection of the second sub-electrode of at least one of the source and drain on the substrate and an overlapping region between an orthographic projection of the first sub-electrode of the at least one of the source and the drain on the substrate and the orthographic projection of the active layer on the substrate.

Reference document D2 (Pub. No. US2022/0013549A1) discloses a display device including a substrate; a light blocking layer of a driving transistor and an active layer of a switching transistor on the substrate; a buffer layer on the light blocking layer, the buffer layer overlapping the light blocking layer; an active layer of the driving transistor on the buffer layer; a first gate insulating layer on the active layer of the driving transistor and the active layer of the switching transistor; and a first gate electrode on the first gate insulating layer and overlapping the active layer of the driving transistor and a second gate electrode overlapping the active layer of the switching transistor, wherein the light blocking layer and the active layer of the switching transistor are on a same layer.

Reference document D3 (Pub. No. US2015/0214379A1) discloses that the threshold voltage is shifted in a negative or positive direction in some cases by an unspecified factor in a manufacturing process of the thin film transistor. If the amount of shift from 0 V is large, driving voltage is increased, which results in an increase in power consumption of a semiconductor device. Thus, a resin layer having good flatness is formed as a first protective insulating film covering the oxide semiconductor layer, and then a second protective insulating film is formed by a sputtering method or a plasma CVD method under a low power condition over the resin layer. Further, in order to adjust the threshold voltage to a desired value, gate electrodes are provided over and below an oxide semiconductor layer.

### SUMMARY OF INVENTION

An object of the embodiments of the present application is to provide a display panel according to claim 1 and a method of manufacturing the same according to claim 11, that are capable of achieving thin-film transistors with short channels, reducing size of the thin-film transistors, and fulfilling high-resolution display panels.

In order to achieve the above-mentioned object, an embodiment of the present application provides a display panel according to claim 1 including a thin-film transistor, the thin-film transistor including an active portion, and a source electrode and a drain electrode that are contact-connected to the active portion. The display panel further includes a substrate, a first metal layer disposed on the substrate and including the source electrode and the drain electrode, and an active layer disposed on a side of the first metal layer away from the substrate and including the active portion, the active portion including a conductor sublayer and a semiconductor sublayer. The conductor sublayer includes a first conductor subsection and a second conductor subsection spaced apart from each other, and the semiconductor sublayer is connected at least between the first conductor subsection and the second conductor subsection; the active portion comprises a source contact region, a drain contact region, and a channel region located between the source contact region and the drain contact region, wherein the conductor sublayer further comprises an isolation groove located between the first conductor subsection and the second conductor subsection in the channel region, and the semiconductor sublayer is filled at least in the isolation groove; in which the semiconductor sublayer comprises a first subportion filled in the isolation groove and a second subportion extending outside the isolation groove, and the second subportion is located on a side of the first conductor subsection and the second conductor subsection away from the substrate; and an orthographic projection of the first subportion on the substrate is within an orthographic projection of the second subportion on the substrate.

The active portion includes a source contact region, a drain contact region, and a channel region located between the source contact region and the drain contact region. The conductor sublayer further includes an isolation groove located between the first conductor subsection and the second conductor subsection in the channel region, and the semiconductor sublayer is filled at least in the isolation groove.

In some embodiments of the present application, the first conductor subsection extends to the source contact region, the second conductor subsection extends to the drain contact region, the source electrode is electrically connected to the first conductor subsection located in the source contact region, and the drain electrode is electrically connected to the second conductor subsection in the drain contact region.

In some embodiments of the present application, a length of the isolation groove in a first direction is less than a distance between the source contact region and the drain contact region, and the first direction is a direction in which the source contact region points to the drain contact region.

In some embodiments of the present application, the length of the isolation groove in the first direction is less than or equal to 3 microns.

In some embodiments of the present application, the thin-film transistor further includes a gate electrode, and the display panel further includes a second metal layer disposed on a side of the active layer away from the first metal layer. The second metal layer includes the gate electrode located on a side of the active portion away from the substrate, and an orthographic projection of the isolation groove on the substrate is located within a coverage range of an orthographic projection of the gate electrode on the substrate.

In some embodiments of the present application, the display panel further includes an interlayer dielectric layer and a third metal layer disposed on a side of the active layer away from the substrate. The interlayer dielectric layer covers the active layer and the second metal layer, and the third metal layer is located on a side of the interlayer dielectric layer away from the second metal layer. The third metal layer includes a first electrode member, and the first electrode member is electrically connected to the thin-film transistor through the interlayer dielectric layer.

In some embodiments of the present application, the orthographic projection of the isolation groove on the substrate is located within a coverage range of an orthographic projection of the first electrode member on the substrate.

In some embodiments of the present application, the display panel further includes a moisture-oxygen barrier layer disposed between the interlayer dielectric layer and the third metal layer. The orthographic projection of the isolation groove on the substrate is located within a coverage range of an orthographic projection of the moisture-oxygen barrier layer on the substrate.

In some embodiments of the present application, the first metal layer further includes a light shielding portion located between the active portion and the substrate.

In some embodiments of the present application, one end of the source electrode is connected to the active portion, the other end is connected to the light shielding portion, and the source electrode is made of a material same as a material of the light shielding portion.

According to the above object of the present application, an embodiment of the present application further provides a method of manufacturing a display panel, the display panel including a thin-film transistor, the thin-film transistor including an active portion, and a source electrode and a drain electrode that are contact-connected to the active portion.

The method of manufacturing the display panel according to claim 11 including:
providing a substrate, forming a first metal layer on the substrate, wherein the first metal layer includes a source electrode and a drain electrode, and forming an active layer on a side of the first metal layer away from the substrate, wherein the active layer includes the active portion including a conductor sublayer and a semiconductor sublayer, wherein the conductor sublayer includes a first conductor subsection and a second conductor subsection spaced apart from each other, and the semiconductor sublayer is connected at least between the first conductor subsection and the second conductor subsection; the active portion comprises a source contact region, a drain contact region, and a channel region located between the source contact region and the drain contact region, wherein the conductor sublayer further comprises an isolation groove located between the first conductor subsection and the second conductor subsection in the channel region, and the semiconductor sublayer is filled at least in the isolation groove; in which the semiconductor sublayer comprises a first subportion filled in the isolation groove and a second subportion extending outside the isolation groove, and the second subportion is located on a side of the first conductor subsection and the second conductor subsection away from the substrate; and an orthographic projection of the first subportion on the substrate is within an orthographic projection of the second subportion on the substrate.

The present application has advantageous effects as follows: compared with prior art, the active portion in the embodiment of the present application includes the conductor sublayer and the semiconductor sublayer, and the conductor sublayer includes the first conductor subsection and the second conductor subsection spaced apart from each other. The semiconductor sublayer is connected at least between the first conductor subsection and the second conductor subsection, so that the active portion can form a channel in a spaced region between the first conductor subsection and the second conductor subsection, and a smaller-sized channel can be obtained by precise photolithography on the conductor sublayer, thus obtaining the thin-film transistor with an ultra-short channel, thereby effectively improving current passing capacity and mobility of the thin-film transistor, reducing the size of the thin-film transistor, and increasing resolution of the display panel.

### BRIEF DESCRIPTION OF DRAWINGS

The technical solutions and other advantageous effects of the present application will be apparent through the detailed description of the specific embodiments of the present application in conjunction with the accompanying drawings.
FIG. 1 is a schematic structural view of a display panel according to an embodiment of the present application.
FIG. 2 is another schematic structural view of a display panel according to an embodiment of the present application.
FIG. 3 is another schematic structural view of a display panel according to an embodiment of the present application.
FIG. 4 is another schematic structural view of a display panel according to an embodiment of the present application.
FIG. 5 is a flowchart of a method of manufacturing a display panel according to an embodiment of the present application.
FIGs. 6 to 12 are schematic structural views of part of a display panel in a manufacturing process according to an embodiment of the present application.

### DESCRIPTION OF PREFERRED EMBODIMENTS

The technical solutions in the embodiments of the present application will be clearly and completely described below in conjunction with the drawings in the embodiments of the present application. Obviously, the described embodiments are only a part of the embodiments of the present application, rather than all the embodiments. Based on the embodiments in this application, all other embodiments obtained by those skilled in the art without creative work shall fall within the protection scope of this application.

The following disclosure provides many different embodiments or examples for implementing different structures of the present application. To simplify the disclosure of the present application, the components and arrangements of specific examples are described below. Of course, they are only examples and are not intended to limit the application. Furthermore, this application may repeat reference numerals and/or reference letters in different instances for the purpose of simplicity and clarity, and does not in itself indicate the relationship between the various embodiments-and/or arrangements discussed. Moreover, this application provides examples of various specific processes and materials, but one of ordinary skill in the art will recognize the application of other processes and/or the use of other materials.

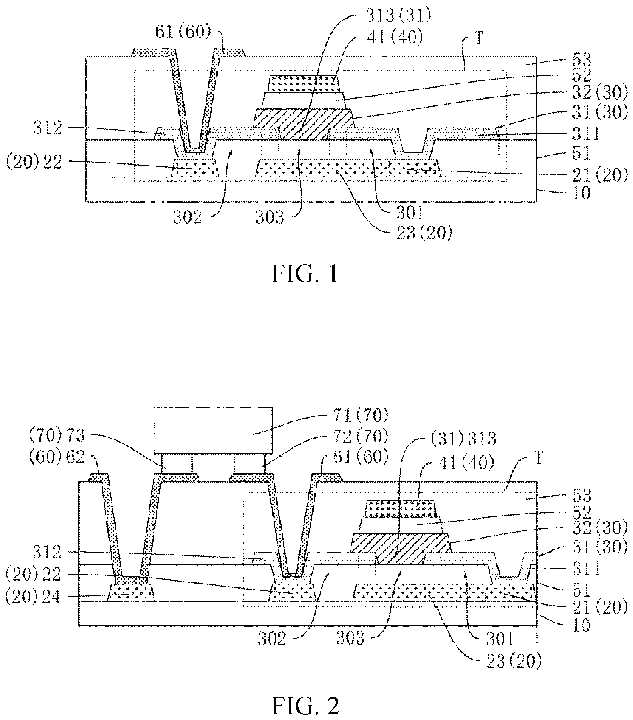

An embodiment of the present application provides a display panel. Referring to FIG. 1, the display panel includes a thin-film transistor T, the thin-film transistor T includes an active portion 30, and a source electrode 21 and a drain electrode 22 that are contact-connected to the active portion 30.

Further, the display panel further includes a substrate 10, a first metal layer 20, and an active layer. The first metal layer 20 is disposed on the substrate 10 and includes a source electrode 21 and a drain electrode 22. The active layer is disposed on a side of the first metal layer 20 away from the substrate 10, and includes an active portion 30, and the active portion 30 includes a conductor sublayer 31 and a semiconductor sublayer 32.

Specifically, the conductor sublayer 31 includes a first conductor subsection 311 and a second conductor subsection 312 spaced apart from each other, and the semiconductor sublayer 32 is connected at least between the first conductor subsection 311 and the second conductor subsection 312.

In practical application processes, the active portion 30 in the embodiment of the present application includes the conductor sublayer 31 and the semiconductor sublayer 32, and the conductor sublayer 31 includes the first conductor subsection 311 and the second conductor subsection 312 spaced apart from each other. The semiconductor sublayer 32 is connected at least between the first conductor subsection 311 and the second conductor subsection 312, so that the active portion 30 can form a channel in a spaced region between the first conductor subsection 311 and the second conductor subsection 312, and a smaller-sized channel can be obtained by precise photolithography on the conductor sublayer 31, thus obtaining the thin-film transistor T with an ultra-short channel, thereby effectively improving current passing capacity and mobility of the thin-film transistor T, reducing a size of the thin-film transistor T, and increasing resolution of the display panel.

Specifically, please continue to refer to FIG. 1. In an embodiment of the present application, the display panel includes the substrate 10, the first metal layer 20 disposed on the substrate 10, an insulating layer 51 disposed on the substrate 10 and covering the first metal layer 20, the active layer disposed on the insulating layer 51, a gate insulating layer 52 disposed on the active layer, a second metal layer 40 disposed on the insulating layer 52, an interlayer dielectric layer 53 disposed on the insulating layer 51 and covering the active layer, the gate insulating layer 52, and the second metal layer 40, and the third metal layer 60 disposed on the interlayer dielectric layer 53.

It should be noted that the display panel provided in the embodiment of the present application includes a plurality of thin-film transistors T, and each of the thin-film transistors T includes the active portion 30, the source electrode 21, the drain electrode 22, and the gate electrode 41 .

Further, the first metal layer 20 includes a plurality of the source electrodes 21 and a plurality of the drain electrodes 22, the active layer includes a plurality of the active portions 30, and the second metal layer 40 includes a plurality of the gate electrodes 41. Specifically, in a same thin-film transistor T, the source electrode 21 and the drain electrode 22 are located between a corresponding one of the active portions 30 and the substrate 10, and two sides of the active portion 30 are contact-connected to the source electrode 21 and the drain electrode 22 through via holes extending through the insulating layer 51, respectively, and the gate electrode 41 is located on a side of the gate insulating layer 52 away from the active portion 30.

In the embodiment of the present application, the first metal layer 20 further includes a plurality of light shielding portions 23, and each of the light shielding portions 23 is disposed corresponding to an active portion 30 to prevent ambient light or reflected light from irradiating the active portion 30, thus adversely affecting electrical stability of the active portion 30. In addition, in a same thin-film transistor T, one end of the source electrode 21 is connected to the active portion 30, and the other end is connected to the light shielding portion 23.

Preferably, the source electrode 21 is made of a material same as a material of the light shielding portion 23, and the source electrode 21 and the light shielding portion 23 are integrally formed. Furthermore, compared with prior art, in the embodiment of the present application, the source electrode 21 and the drain electrode 22 are arranged in a same layer as the light shielding portion 23, so that they can be formed through a same photomask, which saves process steps and reduces process cost.

Further, since the source electrode 21, the drain electrode 22, and the light shielding portion 23 are all incorporated into the first metal layer 20 in the embodiment of the present application, number of insulating film layers covering the source and drain electrodes will be reduced compared with the prior art, so that number of the film layers that block moisture and oxygen above the active portion 30 is reduced. However, in the embodiment of the present application, the gate electrode 41 is disposed above the active portion 30, which can effectively block moisture and oxygen, and improve the stability of the thin-film transistor T. That is, the embodiment of the present application can ensure the stability of the thin-film transistor T and improve the yield of the display panel on the basis of simplifying a process flow and reducing the process cost. In addition, compared with the prior art, a conventional gate electrode is located under a semiconductor layer, so that a film layer under the semiconductor layer is uneven, causing the semiconductor layer to form slope-like structures, which is prone to the risk of disconnection. In contrast, in the embodiment of the present application, the gate electrode 41 is disposed above the active portion 30, preventing the slope-like structure of the active portion 30, reducing the risk of disconnection of the active portion 30, and further improving the yield of the thin-film transistor T.

As noted above, in the embodiment of the present application, each active portion 30 has a source contact region 301, a drain contact region 302, and a channel region 303 located between the source contact region 301 and the drain contact region 302. Furthermore, the source electrode 21 is electrically connected to part of the active portion 30 located in the source contact region 301, and the drain electrode 22 is electrically connected to part of the active portion 30 located in the drain contact region 302.

Each of the active portions 30 includes the conductor sublayer 31 and the semiconductor sublayer 32. Specifically, the conductor sublayer 31 includes the first conductor subsection 311 and the second conductor subsection 312 spaced apart from each other, and an isolation groove 313 located between the first conductor subsection 311 and the second conductor subsection 312, and the isolation groove 313 is situated in the channel region 303. At least the first conductor subsection 311 extends into the source contact region 301, and at least the second conductor subsection 312 extends into the drain contact region 302. Specifically, the source electrode 21 is contact-connected to the first conductor subsection 311 located in the source contact region 301 through a source electrode contact hole extending through the insulating layer 51. The drain electrode 22 is contact-connected to the second conductor subsection 312 in the drain contact region 302 through a drain contact hole extending through the insulating layer 51.

It can be understood that, in the embodiment of the present application, the semiconductor sublayer 32 is connected at least between the first conductor subsection 311 and the second conductor subsection 312. Further, The semiconductor sublayer 32 is filled at least in the isolation groove 313 to form a channel in the channel region 303. In addition, the semiconductor sublayer 32 may also be filled in the isolation groove 313 and extend partially to the source contact region 301 and/or partially to the drain contact region 302. Specifically, the semiconductor sublayer 32 may include a first subportion filled in the isolation groove 313 and a second subportion extending outside the isolation groove 313, and the second subportion is located on a side of the conductor sublayer 31 away from the substrate 10.

Optionally, the conductor sublayer 31 may be made of a material including at least one of indium tin oxide (ITO) or indium zinc oxide (IZO), whereas the semiconductor sublayer 32 may be made of a material including at least one of indium gallium zinc oxide (IGZO), indium gallium tin oxide (IGTO), or indium gallium zinc tin oxide (IGZTO).

Optionally, a thickness of the conductor sublayer 31 may be greater than or equal to 750 angstroms and less than or equal to 1000 angstroms, and a thickness of those semiconductor sublayer 32 may be about 300 angstroms.

Specifically, a length of the isolation groove 313 in a first direction is less than a distance between the source contact region 301 and the drain contact region 302, and the first direction is a direction in which the source contact region 301 points to the drain contact region 302. In this embodiment of the present application, the precise photolithography process on the conductor sublayer 31 can be used to precisely control the length of the isolation groove 313, and the isolation groove 313 with a shorter length can be obtained, that is, the thin-film transistor T with a short channel can be obtained. In the embodiment of the present application, the length of the isolation groove 313 in the first direction is less than or equal to 3 micrometers. Compared with the prior art, a length of a current channel is generally determined by a length of a gate, so that the length of the current channel is generally about 8 microns. In contrast, in the embodiments of the present application, a channel length of the thin-film transistor T can be effectively reduced, so that the current passing capability and mobility of the thin-film transistor T can be improved. In addition, the embodiments of the present application can also reduce the size of the thin-film transistor T by reducing the channel length of the thin-film transistor T, thereby saving more space to increase the number of thin-film transistors T, and improving the resolution of the display panel.

Further, in the embodiment of the present application, the source electrode 21 is contact-connected to the first conductor subsection 311, the drain electrode 22 is contact-connected to the second conductor subsection 312, and the semiconductor sublayer 32 is only configured to form the channel. Therefore, in this embodiment of the present application, the semiconductor sublayer 32 does not need to be subjected to conducting treatment. In the prior art, during a conductorization process of a semiconductor layer, requirements for equipment stability and process time control are extremely strict, and a slight fluctuation will greatly affect electrical properties of devices. For this reason, the embodiments of the present application can effectively simplify the process flow, reduce the difficulty of the process, and improve the yield of the display panel.

In the embodiment of the present application, an orthographic projection of the isolation groove 313 on the substrate 10 is within a coverage range of an orthographic projection of the gate electrode 41 on the substrate 10. In this manner, the gate electrode 41 effectively prevents ions in a film layer above the gate electrode 41 and ions in the environment from diffusing into the active portion 30, thereby reducing the influence of ion diffusion on the semiconductor sublayer 32 located in the channel region 303, thus improving the reliability and stability of the thin-film transistor T.

In addition, the third metal layer 60 includes a first electrode member 61, and the first electrode member 61 is electrically connected to the thin-film transistor T through a via hole extending through the interlayer dielectric layer 53. Specifically, the first electrode member 61 is contact-connected to the second conductive subsection 312 through a via hole extending through the interlayer dielectric layer 53, so as to realize the electrical connection between the first electrode member 61 and the drain electrode 22 for signal transmission.

Specifically, referring to FIG. 2, in the embodiment of the present application, the display panel may be a mini/micro light-emitting diode (LED) display panel. Specifically, the first metal layer 20 further includes a signal transmission portion 24, the third metal layer 60 further includes a second electrode member 62, and the second electrode member 62 is contact-connected to the signal transmission portion 24 through a via hole extending through the interlayer dielectric layer 53 and the insulating layer 51. The display panel further includes an LED element 70. The LED element 70 includes a light-emitting body 71, and a third electrode member 72 and a fourth electrode member 73 arranged on a side of the light-emitting body 71. Specifically, the third electrode member 72 is contact-connected to the first electrode member 61, and the fourth electrode member 73 is contact-connected to the second electrode member 62 so as to transmit electrical signals to the LED element 70 to achieve light emission of the LED element 70.

It should be noted that when the display panel provided by the embodiment of the present application is an organic light-emitting diode (OLED) display panel, the first electrode member 61 may be an anode in the OLED display panel, and the second electrode member 62 may be located in a non-display area of the OLED display panel and connected to a surface cathode of the OLED display panel, so as to obtain an OLED display panel with a short channel. Further, in this embodiment of the present application, positions of the source electrode 21 and the drain electrode 22 may be interchanged, which is not limited herein.

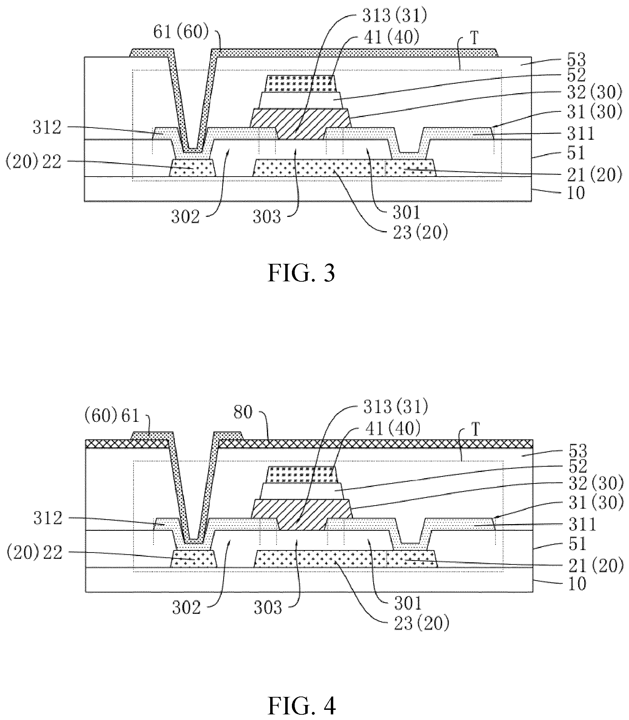

In another embodiment of the present application, referring to FIG. 3, a difference between this embodiment and the previous embodiment is that a coverage area of the first electrode member 61 is increased, so that the orthographic projection of the isolation groove 313 on the substrate 10 is located within the coverage range of an orthographic projection of the first electrode member 61 on the substrate 10. Since the source electrode 21, the drain electrode 22, and the light shielding portion 23 are all incorporated into the first metal layer 20 in the embodiment of the present application, number of insulating film layers covering the source and drain electrodes will be reduced compared with the prior art, so that number of the film layers that block moisture and oxygen above the active portion 30 is reduced. However, in the embodiment of the present application, the coverage area of the first electrode member 61 is increased, so that the first electrode member 61 can cover the channel region 303 of the active portion 30, thereby effectively blocking water and oxygen and improving the stability of the thin-film transistor T. That is, the embodiment of the present application can ensure the stability of the thin-film transistor T and improve the yield of the display panel on the basis of simplifying the process flow and reducing the process cost.

Optionally, an orthographic projection of the thin-film transistor T on the substrate 10 is located within the coverage range of the orthographic projection of the first electrode member 61 on the substrate 10.

In another embodiment of the present application, referring to FIG. 4, a difference between this embodiment and the first embodiment is that the display panel further includes a moisture-oxygen barrier layer 80 disposed between the interlayer dielectric layer 53 and the third metal layer 60, so that the orthographic projection of the isolation groove 313 on the substrate 10 is located within a coverage range of an orthographic projection of the moisture-oxygen barrier layer 80 on the substrate 10. Since the source electrode 21, the drain electrode 22, and the light shielding portion 23 are all incorporated into the first metal layer 20 in the embodiment of the present application, the number of insulating film layers covering the source and drain electrodes will be reduced compared with the prior art, so that the number of the film layers located above the active portion 30 to block moisture and oxygen is reduced. However, in the embodiment of the present application, the moisture-oxygen barrier layer 80 is disposed above the channel region 303 of the active portion 30, thereby effectively blocking moisture and oxygen and improving the stability of the thin-film transistor T, that is, the embodiment of the present application can ensure the stability of the thin-film transistor T and improve the yield of the display panel on the basis of simplifying the process flow and reducing the process cost.

Optionally, the orthographic projection of the thin-film transistor T on the substrate 10 is located within the coverage area of the orthographic projection of the water-oxygen barrier layer 80 on the substrate 10, and the first electrode member 61 passes through the moisture-oxygen barrier layer 80 and the interlayer dielectric layer 53 to be contact-connected to the second conductor subsection 312 in order to achieve electrical connection between the first electrode member 61 and the drain electrode 22. Further, the moisture-oxygen barrier layer 80 can also cover an entire display area of the display panel.

Optionally, the moisture-oxygen barrier layer 80 is made of a material including aluminum oxide (AlOx) or titanium oxide (TiOx). A thickness of the moisture-oxygen barrier layer 80 is greater than or equal to 500 angstroms and less than or equal to 1000 angstroms.

Accordingly, the active portion 30 in the embodiment of the present application includes the conductor sublayer 31 and the semiconductor sublayer 32, and the conductor sublayer 31 includes the first conductor subsection 311 and the second conductor subsection 312 spaced apart from each other. The semiconductor sublayer 32 is connected at least between the first conductor subsection 311 and the second conductor subsection 312, so that the active portion 30 can form a channel in a spaced region between the first conductor subsection 311 and the second conductor subsection 312, and a smaller-sized channel can be obtained by precise photolithography on the conductor sublayer 31, thus obtaining the thin-film transistor T with an ultra-short channel, thereby effectively improving current passing capacity and mobility of the thin-film transistor T, reducing the size of the thin-film transistor T, and increasing the resolution of the display panel.

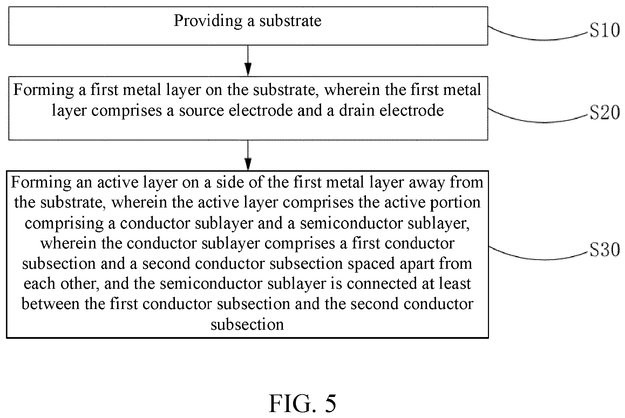

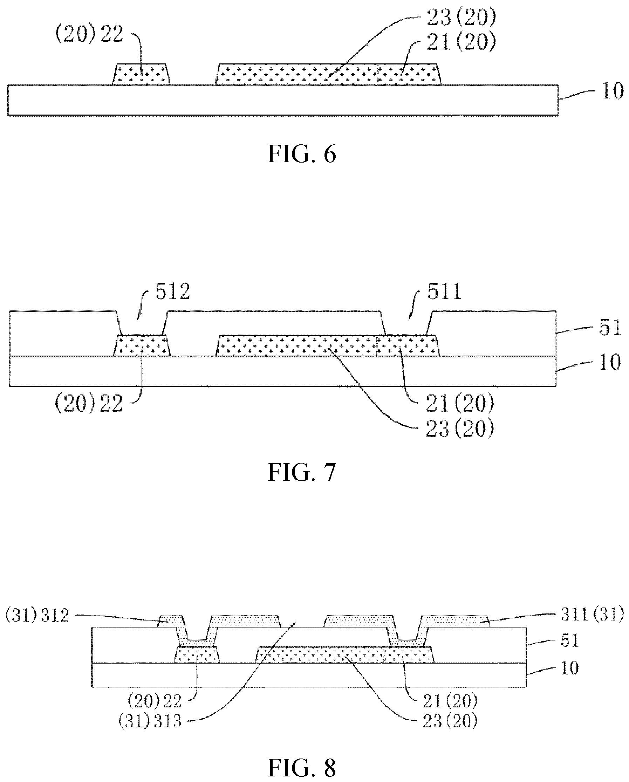

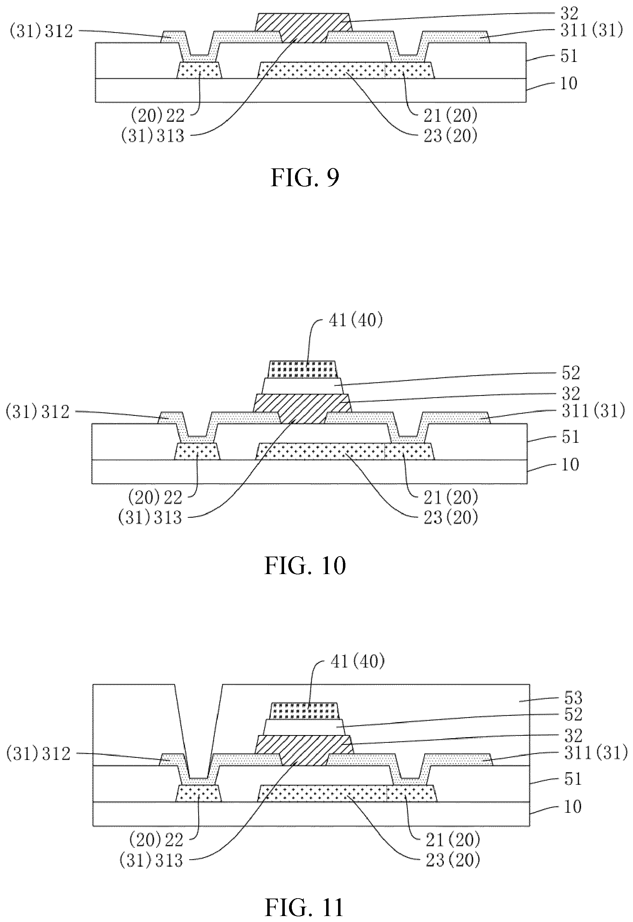

Furthermore, referring to FIGs. 1, 5, and 6 to 11, the display panel according to the embodiment of the present application includes the thin-film transistor T, and the thin-film transistor T includes the active portion 30, and the source electrode 21 and the drain electrode 22 that are contact-connected to the active portion 30.

A method of manufacturing the display panel includes: Step S10: providing a substrate 10.

The substrate 70 may be a glass substrate.

Step S20: forming a first metal layer 20 on the substrate 10, and the first metal layer 20 includes a source electrode 21 and a drain electrode 22.

A first metal material layer is deposited on the substrate 10 by a physical vapor sputtering method, and the first metal material layer is patterned to obtain the first metal layer 20, wherein the first metal layer 20 includes a plurality of the source electrodes 21, a plurality of the drain electrodes 22, and a plurality of light shielding portions 23. Specifically, each of the source electrodes 21 is correspondingly connected to one of the light shielding portions 23, and the source electrode 21 and the corresponding light shielding portion 23 are integrally formed.

Optionally, the first metal material layer may be made of a material including at least one of molybdenum (Mo) and copper (Cu).

Step S30: forming an active layer on a side of the first metal layer 20 away from the substrate 10. The active layer includes an active portion 30 including a conductor sublayer 31 and a semiconductor sublayer 32. The conductor sublayer 31 includes a first conductor subsection 311 and a second conductor subsection 312 spaced apart from each other, and the semiconductor sublayer 32 is connected at least between the first conductor subsection 311 and the second conductor subsection 312.

A chemical vapor deposition method is performed to form an insulating material layer on the substrate 10, and the insulating material layer is subjected to high temperature annealing treatment for 2 to 3 hours, and the temperature may be 300°C to 400°C to obtain an insulating layer 51.

Optionally, the insulating material layer may be made of a material including at least one of silicon nitride (SiNx) and silicon oxide (SiOx).

Next, the insulating layer 51 is patterned to obtain a source contact hole 511 and a drain contact hole 512.

A metal oxide layer is deposited on the insulating layer 51, and the metal oxide layer is patterned to obtain a plurality of the conductor sublayers 31. In addition, the conductor sublayers 31 are located above and arranged in a one-to-one correspondence with the source electrodes 21 and the drain electrodes 22. The conductor sublayers 31 are contact-connected to the source electrode 21 and the drain electrode 22 through the source contact hole 511 and the drain contact hole 512, respectively.

Specifically, in the process of patterning the metal oxide layer, in addition to forming the conductor sublayers 31, the first conductor subsection 311 and the second conductor subsection 312 spaced apart from each other are formed in each of the conductor sublayers 31, and an isolation groove 313 is formed between the first conductor subsection 311 and the second conductor subsection 312. Specifically, the first conductor subsection 311 is contact-connected to the source electrode 21 through the source contact hole 511, and the second conductor subsection 312 is contact-connected to the drain electrode 22 through the drain contact hole 512.

Optionally, the metal oxide layer is made of a material including at least one of ITO or IZO. A thickness of the conductor sublayer 31 is greater than or equal to 750 angstroms and less than or equal to 1000 angstroms.

Then, an oxide semiconductor layer is formed on the conductor sublayer 31 and the insulating layer 51 by a physical vapor sputtering method, and the oxide semiconductor layer is subjected to patterning to obtain a plurality of the semiconductor sublayers 32. Each semiconductor sublayer 32 is located on one conductor sublayer 31 correspondingly. Specifically, each semiconductor sublayer 32 is filled in the isolation groove 313 of a corresponding one of the conductor sublayers 31, and partially extends to the side of the conductor sublayer 31 away from the substrate 10. In addition, one conductor sublayer 31 and one semiconductor sublayer 32 together form one active portion 30.

Optionally, a material of the oxide semiconductor layer includes at least one of IGZO, IGTO, or IGZTO, and a thickness of the semiconductor sublayer 32 may be about 300 angstroms.

Next, a gate insulating material layer and a second metal material layer are sequentially deposited on the semiconductor sublayer 32 and the insulating layer 51. First, the second metal material layer is patterned to obtain a second metal layer 40, and the second metal layer 40 includes a plurality of gate electrodes 41. Each of the gate electrodes 41 is correspondingly located over one active portion 30, and then the gate insulating material layer is patterned by a self-alignment process of the gate electrode 41 to obtain a gate insulating layer 52 located between the gate electrode 41 and the active portion 30.

An interlayer dielectric layer 53 is formed on the gate electrode 41 and the insulating layer 51 by chemical vapor deposition. The interlayer dielectric layer 53 covers the active portion 30, the gate electrode 41, and the insulating layer 51. Then, the interlayer dielectric layer 53 is subjected to an opening process to expose part of an upper surface of the drain electrode 22.

Optionally, the interlayer dielectric layer 53 is made of a material including at least one of SiOx or SiNx.

A physical vapor deposition method is used to form an electrode material layer on the interlayer dielectric layer 53, and the electrode material layer is patterned to obtain a third metal layer 60. The third metal layer 60 includes a first electrode member 61 being contact-connected to the drain electrode 22 through a via hole extending through the interlayer dielectric layer 53 to achieve electrical signal transmission, as shown in FIG. 1.

Optionally, a material of the electrode material layer may include at least one of IZO or ITO.

In another embodiment of the present application, referring to FIG. 3, in the process of patterning the electrode material layer, a coverage area of the first electrode member 61 can be increased, so that the orthographic projection of the isolation groove 313 on the substrate 10 is located within the coverage range of an orthographic projection of the first electrode member 61 on the substrate 10.

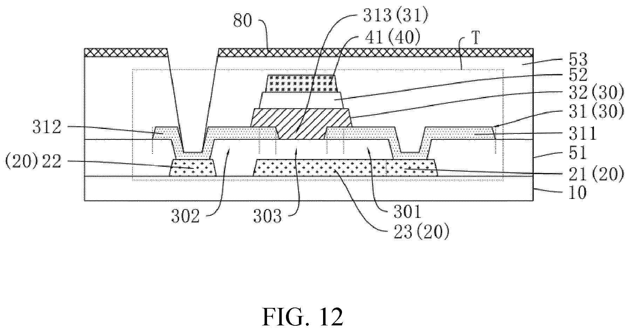

Further, in another embodiment of the present application, referring to FIGs. 4 and 12, after the interlayer dielectric layer 53 is formed, a moisture-oxygen barrier layer 80 is formed on the interlayer dielectric layer 53, so that the orthographic projection of the isolation groove 313 on the substrate 10 is within the coverage range of the orthographic projection of the moisture-oxygen barrier layer 80 on the substrate 10.

Next, a photolithography process may be used to form holes in the moisture-oxygen barrier layer 80 and the interlayer dielectric layer 53 to expose an upper surface of the second conductor subsection 312.

Then, an electrode material layer is formed on the interlayer dielectric layer 53 by a physical vapor deposition method, and the electrode material layer is patterned to obtain a third metal layer 60. The third metal layer 60 includes a first electrode member 61 being contact-connected to the second conductor subsection 312 through a via hole extending through the moisture-oxygen barrier layer 80 and the interlayer dielectric layer 53 to achieve the electrical connection between the first electrode member 61 and the drain electrode 22 for electrical signal transmission, as shown in FIG. 4.

Optionally, the moisture-oxygen barrier layer 80 is made of a material including aluminum oxide (AlOx) or titanium oxide (TiOx). A thickness of the moisture-oxygen barrier layer 80 is greater than or equal to 500 angstroms and less than or equal to 1000 angstroms.

Accordingly, the active portion 30 in the embodiment of the present application includes the conductor sublayer 31 and the semiconductor sublayer 32, and the conductor sublayer 31 includes the first conductor subsection 311 and the second conductor subsection 312 spaced apart from each other. The semiconductor sublayer 32 is connected at least between the first conductor subsection 311 and the second conductor subsection 312, so that the active portion 30 can form a channel in a spaced region between the first conductor subsection 311 and the second conductor subsection 312, and a smaller-sized channel can be obtained by precise photolithography on the conductor sublayer 31, thus obtaining the thin-film transistor T with an ultra-short channel, thereby effectively improving current passing capacity and mobility of the thin-film transistor T, reducing the size of the thin-film transistor T, and increasing the resolution of the display panel.

Furthermore, an embodiment of the present application further provides a display device. The display device includes the display panel described in the above-mentioned embodiments, or includes a display panel and a device main body manufactured by the method of manufacturing the display panel described in the above embodiments in which the display panel and the device main body are combined into one body.

In the embodiment of the present application, the display panel may be the display panel described in the above-mentioned embodiments, and the device main body may include a frame body, a driving module, and the like.

The display device may be a display terminal, such as a mobile phone, a tablet, a television, etc., which is not limited here.

In the above-mentioned embodiments, the description of each embodiment has its own emphasis. For parts that are not described in detail in an embodiment, reference may be made to related descriptions of other embodiments.

The display panel and the method of manufacturing the same provided by the embodiments of the present application are described in detail above. The principles and implementations of the present application are described with specific examples herein. The descriptions of the above embodiments are only used to help understand the technical solutions and kernel ideas of the present disclosure; those of ordinary skill in the art should understand that they can still modify the technical solutions described in the foregoing embodiments, whereas these modifications or substitutions do not deviate the essence of the corresponding technical solutions from the scope of the technical solutions of the embodiments of the present disclosure.

## Claims

1. A display panel, **characterized in that** the display panel comprises a thin-film transistor (T), the thin-film transistor (T) comprising an active portion (30), and a source electrode (21) and a drain electrode (22) that are contact-connected to the active portion (30);
wherein the display panel further comprises:
a substrate (10);
a first metal layer (20) disposed on the substrate (10) and comprising the source electrode (21) and the drain electrode (22); and
an active layer disposed on a side of the first metal layer (20) away from the substrate (10) and comprising the active portion (30), and the active portion (30) comprising a conductor sublayer (31) and a semiconductor sublayer (32);
wherein the conductor sublayer (31) comprises a first conductor subsection (311) and a second conductor subsection (312) spaced apart from each other, and the semiconductor sublayer (32) is connected at least between the first conductor subsection (311) and the second conductor subsection (312);
the active portion (30) comprises a source contact region (301), a drain contact region (302), and a channel region (303) located between the source contact region (301) and the drain contact region (302), wherein the conductor sublayer (31) further comprises an isolation groove (313) located between the first conductor subsection (311) and the second conductor subsection (312) in the channel region (303), and the semiconductor sublayer (32) is filled at least in the isolation groove (313);
wherein the semiconductor sublayer (32) comprises a first subportion filled in the isolation groove (313) and a second subportion extending outside the isolation groove, and the second subportion is located on a side of the first conductor subsection (311) and the second conductor subsection (312) away from the substrate (10); and an orthographic projection of the first subportion on the substrate is within an orthographic projection of the second subportion on the substrate.

2. The display panel of claim 1, **characterized in that** the first conductor subsection (311) extends to the source contact region (301), the second conductor subsection (312) extends to the drain contact region (302), the source electrode (21) is electrically connected to the first conductor subsection (311) located in the source contact region (301), and the drain electrode (22) is electrically connected to the second conductor subsection (312) in the drain contact region (302).

3. The display panel of claim 1, **characterized in that** a length of the isolation groove (313) in a first direction is less than a distance between the source contact region (301) and the drain contact region (302), and the first direction is a direction in which the source contact region (301) points to the drain contact region (302).

4. The display panel of claim 3, **characterized in that** the length of the isolation groove (313) in the first direction is less than or equal to 3 microns.

5. The display panel of claim 1, **characterized in that** the thin-film transistor (T) further comprises a gate electrode (41), and the display panel further comprises a second metal layer (40) disposed on a side of the active layer away from the first metal layer (20), wherein the second metal layer (40) comprises the gate electrode (41) located on a side of the active portion (30) away from the substrate (10), and an orthographic projection of the isolation groove (313) on the substrate (10) is located within a coverage range of an orthographic projection of the gate electrode (41) on the substrate (10).

6. The display panel of claim 5, **characterized in that** the display panel further comprises an interlayer dielectric layer (53) and a third metal layer (60) disposed on a side of the active layer away from the substrate (10), wherein the interlayer dielectric layer (53) covers the active layer and the second metal layer (40), and the third metal layer (60) is located on a side of the interlayer dielectric layer (53) away from the second metal layer (40);
wherein the third metal layer (60) comprises a first electrode member (61), and the first electrode member (61) is electrically connected to the thin-film transistor (T) through the interlayer dielectric layer (53).

7. The display panel of claim 6, **characterized in that** the orthographic projection of the isolation groove (313) on the substrate (10) is located within a coverage range of an orthographic projection of the first electrode member (61) on the substrate (10).

8. The display panel of claim 6, **characterized in that** the display panel further comprises a moisture-oxygen barrier layer (80) disposed between the interlayer dielectric layer (53) and the third metal layer (60), wherein the orthographic projection of the isolation groove (313) on the substrate (10) is located within a coverage range of an orthographic projection of the moisture-oxygen barrier layer (80) on the substrate (10).

9. The display panel of claim 1, **characterized in that** the first metal layer (20) further comprises a light shielding portion (23) located between the active portion (30) and the substrate (10).

10. The display panel of claim 9, **characterized in that** one end of the source electrode (21) is connected to the active portion (30), the other end is connected to the light shielding portion (23), and the source electrode (21) is made of a material same as a material of the light shielding portion (23).

11. A method of manufacturing a display panel, **characterized in that** the display panel comprises a thin-film transistor (T), the thin-film transistor (T) comprising an active portion (30), and a source electrode (21) and a drain electrode (22) that are contact-connected to the active portion (30), and
the method of manufacturing the display panel comprising:
providing a substrate (10);
forming a first metal layer (20) on the substrate (10), wherein the first metal layer (20) comprises a source electrode (21) and a drain electrode (22); and
forming an active layer on a side of the first metal layer (20) away from the substrate (10), wherein the active layer comprises the active portion (30) comprising a conductor sublayer (31) and a semiconductor sublayer (32), wherein the conductor sublayer (31) comprises a first conductor subsection (311) and a second conductor subsection (312) spaced apart from each other, and the semiconductor sublayer (32) is connected at least between the first conductor subsection (311) and the second conductor subsection (312);
the active portion (30) comprises a source contact region (301), a drain contact region (302), and a channel region (303) located between the source contact region (301) and the drain contact region (302), wherein the conductor sublayer (31) further comprises an isolation groove (313) located between the first conductor subsection (311) and the second conductor subsection (312) in the channel region (303), and the semiconductor sublayer (32) is filled at least in the isolation groove (313);
wherein the semiconductor sublayer (32) comprises a first subportion filled in the isolation groove (313) and a second subportion extending outside the isolation groove, and the second subportion is located on a side of the first conductor subsection (311) and the second conductor subsection (312) away from the substrate (10); and an orthographic projection of the first subportion on the substrate is within an orthographic projection of the second subportion on the substrate.

## Patentansprüche

1. Eine Anzeigepanel, **dadurch gekennzeichnet, dass** die Anzeigepanel einen Dünnschichttransistor (T) umfasst, wobei der Dünnschichttransistor (T) einen aktiven Bereich (30) sowie eine Source-Elektrode (21) und eine Drain-Elektrode (22) umfasst, die mit dem aktiven Bereich (30) kontaktiert sind;
wobei die Anzeigepanel ferner umfasst:
ein Substrat (10);
eine erste Metallschicht (20), die auf dem Substrat (10) angeordnet ist und die Source-Elektrode (21) sowie die Drain-Elektrode (22) umfasst; sowie
eine aktive Schicht, die auf einer vom Substrat (10) abgewandten Seite der ersten Metallschicht (20) angeordnet ist und den aktiven Bereich (30) umfasst, wobei der aktive Bereich (30) eine Leiterunterschicht (31) und eine Halbleiterunterschicht (32) umfasst;
wobei die Leiterunterschicht (31) einen ersten Leiterunterabschnitt (311) und einen zweiten Leiterunterabschnitt (312) umfasst, die voneinander beabstandet sind, und die Halbleiterunterschicht (32) zumindest zwischen dem ersten Leiterunterabschnitt (311) und dem zweiten Leiterunterabschnitt (312) verbunden ist;
der aktive Bereich (30) einen Source-Kontaktbereich (301), einen Drain-Kontaktbereich (302) und einen Kanalbereich (303) umfasst, der zwischen dem Source-Kontaktbereich (301) und dem Drain-Kontaktbereich (302) angeordnet ist, wobei die Leiterunterschicht (31) ferner eine Isolationsnut (313) umfasst, die sich im Kanalbereich (303) zwischen dem ersten Leiterunterabschnitt (311) und dem zweiten Leiterunterabschnitt (312) befindet, und die Halbleiterunterschicht (32) zumindest in der Isolationsnut (313) ausgefüllt ist;
wobei die Halbleiterunterschicht (32) einen ersten Teilabschnitt, der in der Isolationsnut (313) ausgefüllt ist, und einen zweiten Teilabschnitt, der sich außerhalb der Isolationsnut erstreckt, umfasst, und der zweite Teilabschnitt auf einer vom Substrat (10) abgewandten Seite des ersten Leiterunterabschnitts (311) und des zweiten Leiterunterabschnitts (312) angeordnet ist; und eine orthographische Projektion des ersten Teilabschnitts auf das Substrat liegt innerhalb einer orthographischen Projektion des zweiten Teilabschnitts auf das Substrat.

2. Anzeigepanel nach Anspruch 1, **dadurch gekennzeichnet, dass** sich der erste Leiterunterabschnitt (311) bis zum Source-Kontaktbereich (301) erstreckt, sich der zweite Leiterunterabschnitt (312) bis zum Drain-Kontaktbereich (302) erstreckt, die Source-Elektrode (21) elektrisch mit dem im Source-Kontaktbereich (301) befindlichen ersten Leiterunterabschnitt (311) verbunden ist und die Drain-Elektrode (22) elektrisch mit dem zweiten Leiterunterabschnitt (312) im Drain-Kontaktbereich (302) verbunden ist.

3. Anzeigepanel nach Anspruch 1, **dadurch gekennzeichnet, dass** eine Länge der Isolationsnut (313) in einer ersten Richtung kleiner ist als ein Abstand zwischen dem Source-Kontaktbereich (301) und dem Drain-Kontaktbereich (302), und die erste Richtung eine Richtung ist, in der der Source-Kontaktbereich (301) auf den Drain-Kontaktbereich (302) zeigt.

4. Anzeigepanel nach Anspruch 3, **dadurch gekennzeichnet, dass** die Länge der Isolationsnut (313) in der ersten Richtung kleiner oder gleich 3 Mikrometer ist.

5. Anzeigepanel nach Anspruch 1, **dadurch gekennzeichnet, dass** der Dünnschichttransistor (T) ferner eine Gate-Elektrode (41) umfasst und die Anzeigepanel ferner eine zweite Metallschicht (40) umfasst, die auf einer von der ersten Metallschicht (20) abgewandten Seite der aktiven Schicht angeordnet ist, wobei die zweite Metallschicht (40) die Gate-Elektrode (41) umfasst, die sich auf einer vom Substrat (10) abgewandten Seite des aktiven Bereichs (30) befindet, und eine orthographische Projektion der Isolationsnut (313) auf das Substrat (10) innerhalb eines Abdeckungsbereichs einer orthographischen Projektion der Gate-Elektrode (41) auf das Substrat (10) liegt.

6. Anzeigepanel nach Anspruch 5, **dadurch gekennzeichnet, dass** die Anzeigepanel ferner eine dielektrische Zwischenschicht (53) und eine dritte Metallschicht (60) umfasst, die auf einer vom Substrat (10) abgewandten Seite der aktiven Schicht angeordnet ist, wobei die dielektrische Zwischenschicht (53) die aktive Schicht und die zweite Metallschicht (40) bedeckt, und die dritte Metallschicht (60) auf einer von der zweiten Metallschicht (40) abgewandten Seite der dielektrischen Zwischenschicht (53) angeordnet ist;
wobei die dritte Metallschicht (60) ein erstes Elektrodenelement (61) umfasst und das erste Elektrodenelement (61) über die dielektrische Zwischenschicht (53) elektrisch mit dem Dünnschichttransistor (T) verbunden ist.

7. Anzeigepanel nach Anspruch 6, **dadurch gekennzeichnet, dass** die orthographische Projektion der Isolationsnut (313) auf dem Substrat (10) innerhalb eines Abdeckungsbereichs einer orthographischen Projektion des ersten Elektrodenelements (61) auf dem Substrat (10) liegt.

8. Anzeigepanel nach Anspruch 6, **dadurch gekennzeichnet, dass** die Anzeigepanel ferner eine Feuchtigkeits- und Sauerstoffsperrschicht (80) umfasst, die zwischen der dielektrischen Zwischenschicht (53) und der dritten Metallschicht (60) angeordnet ist, wobei die orthographische Projektion der Isolationsnut (313) auf dem Substrat (10) innerhalb eines Abdeckungsbereichs einer orthographischen Projektion der Feuchtigkeits- und Sauerstoffsperrschicht (80) auf dem Substrat (10) liegt.

9. Anzeigepanel nach Anspruch 1, **dadurch gekennzeichnet, dass** die erste Metallschicht (20) ferner einen Lichtabschirmungsabschnitt (23) umfasst, der zwischen dem aktiven Bereich (30) und dem Substrat (10) angeordnet ist.

10. Anzeigepanel nach Anspruch 9, **dadurch gekennzeichnet, dass** ein Ende der Source-Elektrode (21) mit dem aktiven Bereich (30) verbunden ist, das andere Ende mit dem Lichtabschirmungsabschnitt (23) verbunden ist und die Source-Elektrode (21) aus demselben Material besteht wie der Lichtabschirmungsabschnitt (23).

11. Verfahren zur Herstellung einer Anzeigepanel, **dadurch gekennzeichnet, dass** die Anzeigepanel einen Dünnschichttransistor (T) umfasst, wobei der Dünnschichttransistor (T) einen aktiven Bereich (30) sowie eine Source-Elektrode (21) und eine Drain-Elektrode (22) umfasst, die mit dem aktiven Bereich (30) kontaktiert sind, und
das Verfahren zur Herstellung der Anzeigepanel umfasst:
Bereitstellen eines Substrats (10);
Ausbilden einer ersten Metallschicht (20) auf dem Substrat (10), wobei die erste Metallschicht (20) eine Source-Elektrode (21) und eine Drain-Elektrode (22) umfasst; und
Ausbilden einer aktiven Schicht auf einer vom Substrat (10) abgewandten Seite der ersten Metallschicht (20), wobei die aktive Schicht den aktiven Bereich (30) umfasst, der eine Leiterunterschicht (31) und eine Halbleiterunterschicht (32) umfasst, wobei die Leiterunterschicht (31) einen ersten Leiterunterabschnitt (311) und einen zweiten Leiterunterabschnitt (312) umfasst, die voneinander beabstandet sind, und die Halbleiterunterschicht (32) zumindest zwischen dem ersten Leiterunterabschnitt (311) und dem zweiten Leiterunterabschnitt (312) verbunden ist;
der aktive Bereich (30) umfasst einen Source-Kontaktbereich (301), einen Drain-Kontaktbereich (302) und einen Kanalbereich (303), der zwischen dem Source-Kontaktbereich (301) und dem Drain-Kontaktbereich (302) angeordnet ist, wobei die Leiterunterschicht (31) ferner eine Isolationsnut (313) umfasst, die sich im Kanalbereich (303) zwischen dem ersten Leiterunterabschnitt (311) und dem zweiten Leiterunterabschnitt (312) befindet, und die Halbleiterunterschicht (32) zumindest in der Isolationsnut (313) ausgefüllt ist;
wobei die Halbleiterunterschicht (32) einen ersten Teilabschnitt, der in der Isolationsnut (313) ausgefüllt ist, und einen zweiten Teilabschnitt, der sich außerhalb der Isolationsnut erstreckt, umfasst, und der zweite Teilabschnitt auf einer vom Substrat (10) abgewandten Seite des ersten Leiterunterabschnitts (311) und des zweiten Leiterunterabschnitts (312) angeordnet ist; und eine orthographische Projektion des ersten Teilabschnitts auf das Substrat innerhalb einer orthographischen Projektion des zweiten Teilabschnitts auf das Substrat liegt.

## Revendications

1. Un panneau d'affichage, **caractérisé en ce qu'**il comprend un transistor à couche mince (T), ledit transistor à couche mince (T) comprenant une partie active (30), ainsi qu'une électrode de source (21) et une électrode de drain (22) qui sont reliées par contact à la partie active (30) ;
dans lequel le panneau d'affichage comprend en outre :
un substrat (10) ;
une première couche métallique (20) disposée sur le substrat (10) et comprenant l'électrode de source (21) et l'électrode de drain (22) ; et
une couche active disposée sur un côté de la première couche métallique (20) opposé au substrat (10) et comprenant la partie active (30), la partie active (30) comprenant une sous-couche conductrice (31) et une sous-couche semi-conductrice (32) ;
dans lequel la sous-couche conductrice (31) comprend une première sous-section conductrice (311) et une deuxième sous-section conductrice (312) espacées l'une de l'autre, et la sous-couche semi-conductrice (32) est connectée au moins entre la première sous-section conductrice (311) et la deuxième sous-section conductrice (312) ;
la partie active (30) comprend une région de contact de source (301), une région de contact de drain (302) et une région de canal (303) située entre la région de contact de source (301) et la région de contact de drain (302), la sous-couche conductrice (31) comprenant en outre une rainure d'isolation (313) située entre la première sous-section conductrice (311) et la deuxième sous-section conductrice (312) dans la région de canal (303), et la sous-couche semi-conductrice (32) remplissant au moins la rainure d'isolation (313) ;
dans lequel la sous-couche semi-conductrice (32) comprend une première sous-partie remplissant la rainure d'isolation (313) et une deuxième sous-partie s'étendant à l'extérieur de la rainure d'isolation, et la deuxième sous-partie est située sur un côté de la première sous-section conductrice (311) et de la deuxième sous-section conductrice (312) opposé au substrat (10) ; et une projection orthographique de la première sous-partie sur le substrat se trouve à l'intérieur d'une projection orthographique de la deuxième sous-partie sur le substrat.

2. Panneau d'affichage selon la revendication 1, **caractérisé en ce que** la première sous-section conductrice (311) s'étend jusqu'à la région de contact de source (301), la deuxième sous-section conductrice (312) s'étend jusqu'à la région de contact de drain (302), l'électrode de source (21) est connectée électriquement à la première sous-section conductrice (311) située dans la région de contact de source (301), et l'électrode de drain (22) est connectée électriquement à la deuxième sous-section conductrice (312) dans la région de contact de drain (302).

3. Panneau d'affichage selon la revendication 1, **caractérisé en ce que** la longueur de la rainure d'isolation (313) dans une première direction est inférieure à la distance entre la région de contact de source (301) et la région de contact de drain (302), et **en ce que** la première direction est la direction dans laquelle la région de contact de source (301) est orientée vers la région de contact de drain (302).

4. Panneau d'affichage selon la revendication 3, **caractérisé en ce que** la longueur de la rainure d'isolation (313) dans la première direction est inférieure ou égale à 3 microns.

5. Panneau d'affichage selon la revendication 1, **caractérisé en ce que** le transistor à couche mince (T) comprend en outre une électrode de grille (41), et le panneau d'affichage comprend en outre une deuxième couche métallique (40) disposée sur un côté de la couche active opposé à la première couche métallique (20), la deuxième couche métallique (40) comprenant l'électrode de grille (41) située du côté de la partie active (30) opposé au substrat (10), et la projection orthographique de la rainure d'isolation (313) sur le substrat (10) se situant dans la zone de couverture de la projection orthographique de l'électrode de grille (41) sur le substrat (10).

6. Panneau d'affichage selon la revendication 5, **caractérisé en ce que** le panneau d'affichage comprend en outre une couche diélectrique intercouche (53) et une troisième couche métallique (60) disposée sur un côté de la couche active opposé au substrat (10), dans lequel la couche diélectrique intercouche (53) recouvre la couche active et la deuxième couche métallique (40), et la troisième couche métallique (60) est située sur un côté de la couche diélectrique intercouche (53) opposé à la deuxième couche métallique (40) ;
dans lequel la troisième couche métallique (60) comprend un premier élément d'électrode (61), et le premier élément d'électrode (61) est connecté électriquement au transistor à couche mince (T) par l'intermédiaire de la couche diélectrique intercouche (53).

7. Panneau d'affichage selon la revendication 6, **caractérisé en ce que** la projection orthographique de la rainure d'isolation (313) sur le substrat (10) est située dans une zone de couverture d'une projection orthographique du premier élément d'électrode (61) sur le substrat (10).

8. Panneau d'affichage selon la revendication 6, **caractérisé en ce que** le panneau d'affichage comprend en outre une couche barrière contre l'humidité et l'oxygène (80) disposée entre la couche diélectrique intercouche (53) et la troisième couche métallique (60), dans lequel la projection orthographique de la rainure d'isolation (313) sur le substrat (10) se situe dans une zone de couverture d'une projection orthographique de la couche barrière contre l'humidité et l'oxygène (80) sur le substrat (10).

9. Panneau d'affichage selon la revendication 1, **caractérisé en ce que** la première couche métallique (20) comprend en outre une partie de protection contre la lumière (23) située entre la partie active (30) et le substrat (10).

10. Panneau d'affichage selon la revendication 9, **caractérisé en ce qu'**une extrémité de l'électrode de source (21) est reliée à la partie active (30), l'autre extrémité est reliée à la partie de protection contre la lumière (23), et l'électrode de source (21) est constituée d'un matériau identique à celui de la partie de protection contre la lumière (23).

11. Procédé de fabrication d'un panneau d'affichage, **caractérisé en ce que** le panneau d'affichage comprend un transistor à couche mince (T), le transistor à couche mince (T) comprenant une partie active (30), ainsi qu'une électrode de source (21) et une électrode de drain (22) qui sont reliées par contact à la partie active (30), et
le procédé de fabrication du panneau d'affichage comprenant :
la mise en place d'un substrat (10) ;
la formation d'une première couche métallique (20) sur le substrat (10), la première couche métallique (20) comprenant une électrode de source (21) et une électrode de drain (22) ; et
la formation d'une couche active sur une face de la première couche métallique (20) opposée au substrat (10), la couche active comprenant la partie active (30) comprenant une sous-couche conductrice (31) et une sous-couche semi-conductrice (32), la sous-couche conductrice (31) comprenant une première sous-section conductrice (311) et une deuxième sous-section conductrice (312) espacées l'une de l'autre, et la sous-couche semi-conductrice (32) est connectée au moins entre la première sous-section conductrice (311) et la deuxième sous-section conductrice (312) ;
la partie active (30) comprend une région de contact de source (301), une région de contact de drain (302) et une région de canal (303) située entre la région de contact de source (301) et la région de contact de drain (302), dans lequel la sous-couche conductrice (31) comprend en outre une rainure d'isolation (313) située entre la première sous-section conductrice (311) et la deuxième sous-section conductrice (312) dans la région de canal (303), et la sous-couche semi-conductrice (32) remplit au moins la rainure d'isolation (313) ;
dans lequel la sous-couche semi-conductrice (32) comprend une première sous-partie remplissant la rainure d'isolation (313) et une deuxième sous-partie s'étendant à l'extérieur de la rainure d'isolation, et la deuxième sous-partie est située sur un côté de la première sous-section conductrice (311) et de la deuxième sous-section conductrice (312) opposé au substrat (10) ; et une projection orthographique de la première sous-partie sur le substrat se trouve à l'intérieur d'une projection orthographique de la deuxième sous-partie sur le substrat.
